# EUROPEAN PATENT APPLICATION

(11) **EP 4 400 975 A1**
(43) Date of publication of application: **17.07.2024**
(21) Application number: 23150926.6
(22) Date of filing: 10.01.2023
(51) Int. Cl.: G06F 11/36, G06F 30/20, G05B 13/04, B60W 50/00

(54) **METHOD FOR TRAINING A SYSTEM MODEL, SELECTING A CONTROLLER, SYSTEM, COMPUTER-SYSTEM**

(71) Applicant: Siemens Industry Software NV, 3001 Leuven (BE)
(72) Inventor: Tong, Son, 3001 Leuven (BE)
(74) Representative: Siemens Patent Attorneys

(57) **Abstract**

The invention relates to a computer-implemented method for training a predefined system model (MDL) of a parametrized system (SYS), wherein scenarios (SCN) are a parameter set defining a system (SYS) state and/or system (SYS) operation, the method comprising:
(a) providing said system model (MDL),
(b) providing a first set (IST) of scenarios (SCN),
(c) selecting a sub-set (SST) of scenarios (SCN),
(d) acquiring system (SYS) test data (TDT) for the sub-set (SST) of scenarios (SCN),
(e) generating system model (MDL) data for the sub-set (SST) of scenarios (SCN),
(f) determining a modeling error (MER) of the system model (MDL) by comparing the test data (TDT) with the system model (MDL) data.

To reduce the model training complexity the method according to the invention proposes the additional steps:
(g) generating and/or training an error prediction model (EPM) on basis of the modeling errors (MER) determined,
(h) determining an error prediction (ERP) by the error prediction model (EPM) for the first set (IST) of scenarios (SCN),
(i) selecting a certain portion of the first set (IST) of scenarios (SCN) with the highest error prediction (ERP) determined by the error prediction model (EPM) as top error scenarios (TES),
(j) acquiring system (SYS) test data (TDT) for the selected top error scenarios (TES),
(k) training said system model (MDL) with the acquired system (SYS) test data (TDT) for the selected top error scenarios (TES).

## Description

### FIELD OF THE INVENTION

The invention relates to a computer-implemented method for training a predefined system model of a parametrized system, wherein scenarios are a parameter set defining a system state and/or system operation, the method comprising:
(a) providing said system model of a parametrized system,
(b) providing a first set of scenarios of said system,
(c) selecting a sub-set of scenarios,
(d) acquiring system test data for the sub-set of scenarios,
(e) generating system model data for the sub-set of scenarios by applying the system model to said scenarios,
(f) determining a modeling error of the system model by comparing the test data with the system model data.

The invention further deals with selecting a controller, with a system, and a computer-system.

### BACKGROUND OF THE INVENTION

Testing and validation belong to major tasks in the product development process and is one of the main challenges in the industry - in particular for Advanced Driver-Assistance systems [ADAS] and autonomous vehicles [AV] today. There are several reasons for that high challenge: ADAS/AV is a safety-critical application because:
- an accident on road is not acceptable,
- test time - in particular on the road - is expensive,
- government regulations for road testing are restrictive.

Testing in this and other domains is obligatory. The Original Equipment Manufacturers [OEM] and Suppliers must implement and test their algorithms in order to validate and certify their technologies.

Validation of an ADAS/AV-controller requires testing millions of billions of kilometers of road testing. Therefore, scenario-based testing has become critical for verification and validation of ADAS system.

Different stages of technology maturity require different testing intensity. The number of scenarios needed to properly validate ADAS/AV systems will rapidly increase from SAE [Society of Automotive Engineers] level 1 up to SAE level 5. For example, a scenario with 10 parameters and 10 sample points per parameter leads to 10 billion concrete scenarios to test.

The further the development progresses, the more complex and expensive validation and verification [V&V] becomes. Hence it is not possible to increase significantly physical validation to catch up with the requirements. Frontloaded virtual V&V at different virtualization stages becomes more important. Some examples of different virtualization stages in the field of ADAS are:
- Model-in-the-Loop (MiL): the complete ADAS systems, i.e. traffic environment, vehicle dynamics, are modelled and test in simulation.
- Hardware-in-the-Loop (HiL): still making use of virtual vehicle and environment, but one or more components are physical system (i.e. sensors, ECU,...)
- Vehicle-in-the-Loop (ViL): test vehicles in proving ground tracks with dummy objects or virtual traffic

The current development focuses on technologies and coverage of scenario generation in MiL phase, for example, AVL, Foretellix, dSpace, Mathworks... as well as Siemens. The outcomes are often high numbers of scenarios (millions to billions of scenarios). Depending on the scenario generation algorithm and criteria, the scenarios are often mixed of normal (noncritical) and critical scenarios. Some market participants present validation platforms capable of HiL and ViL testing. Since the testing of all scenarios generated is barely possible one possible solution may be an intelligent selection of scenarios to be tested. The available products don't provide strategies for selection. Most often demonstrations are based on few standard scenarios (i.e. from Euro NCAP, AAA).

Some examples of known processes in this context are:
S. Wagner, K. Groh, T. Kühbeck and A. Knoll, "Towards Cross-Verification and Use of Simulation in the Assessment of Automated Driving", 2019 IEEE Intelligent Vehicles Symposium (IV), 2019. https://www.pegasusprojekt.de/files/tmpl/Pegasus-Abschlussveranstaltung/22_Verification.pdf.
H. Abdellatif and C. Gnandt, "Use of Simulation for the Homologation of Automated Driving Functions", https://www.tuvsud.com/en/-/media/global/pdf-files/e-ssentials-documents/atz-electronics-worldwide-122019_tuv-sud-automated-driving.pdf.
E. Böde et al."Efficient Splitting of Test and Simulation Cases for the Verification of Highly Automated Driving Function", https://www.researchgate.net/publication/327066622_Efficient_Splitting_of_Test_and_Simulation_Cases_for_the_Verification_of_Highly_Automated_Driving_Functions_37th_International_Conference_SAFECOMP_2018_Vasteras_Sweden_September_19-21_2018_Proceedings.

Testing a system remains an expensive undertaking. Replacing real physical testing by virtual testing reduces the costs significantly. The effective rate of virtualization is strongly influenced by the quality of the model used for simulation of the system. The gap between simulation and physical systems - the modelling error therefore becomes a major technical challenge. Often the results from simulation are not valid in physical system validation due to sensor noises, vehicle dynamics, complex traffic interactions, disturbances or other causes.

A significant risk in scenario reduction or down-sampling the number of scenarios lies in missing important scenarios and in reducing the coverage of the simulation. In some cases, the selected samples are not even useful to validate the physical system performance.

It can be observed that there is a performance gap between simulation and the real system. For example, tuning a controller in a simulation model may have a different effect than in the real vehicle. The same controller often performs differently, sometimes significantly in MiL, HiL and ViL testing for the same ADAS algorithms pipeline.

Testing of controllers on real vehicles is expensive, time consuming, and involves uncertainty regarding the experimental setup or hardware, GPS, weather, disturbances, road conditions and others.

Based on the prior art described above and the problems associated, it is one objective of the invention to improve the training of a system model in order to most effectively improve the model accuracy.

It is another objective to select training scenarios for the model while simultaneously minimizing the risk of missing out relevant scenarios. This objective may be understood as down-sampling the scenarios, while achieving quantifiable coverage performance.

One more specific objective is down-sampling the number of scenarios to select the most valuable training scenarios.

Still another more specific objective is selecting a controller of a system from a set of different controllers, in particular selecting an ADAS/AV controller to be installed into a vehicle.

### SUMMARY OF THE INVENTION

In accordance with the invention there is provided a solution for the above-described problems by the incipiently defined method comprising the additional steps of:
(g) generating and/or training an error prediction model on basis of the modeling errors determined,
(h) determining an error prediction by the error prediction model for the first set of scenarios,
(i) selecting a certain portion of the first set of scenarios with the highest error prediction determined by the error prediction model as top error scenarios,
(j) acquiring system test data for the selected top error scenarios,
(k) training said system model with the acquired system test data for the selected top error scenarios.

Providing said predefined system model may be done by known modelling technics. These technics may involve modelling tools like Siemens Simcenter or others. Most preferably a model may comprise a neural network which may be improved in accuracy in training modus by providing scenarios as training data.

Providing a first set of scenarios of said system may be done by scenario generation which may be done by using constrained randomization techniques. The constraints may be introduced by setting scenario parameters and/or defining scenario types.

Selecting a sub-set of scenarios may be done arbitrarily or by any strategy. Such a strategy may comprise a technique to select a most representative selection. One preferred strategy to catch most representative scenarios may be a δ-cover selection.

The selected scenarios are subsequently used for real testing and simulation testing. Most preferably the selected scenarios may include most representative and top error scenarios, which may be considered as uncertain scenarios. Accordingly, the real test result performance may be validated quantitatively - in the link with simulation validation results. The simulation validation results may be understood as the full number of scenarios (massive scenarios).

In accordance with the invention there is further provided a method of selecting a controller of a system from a set of different controllers, in particular of selecting an ADAS/AV controller to be installed into a vehicle or of installing a controller into a system, in particular an ADAS/AV controller into vehicle selecting to be to comprising:
- defining system performance indicators,
- providing for each of the controllers of said set of different controllers a controller model,
- Performing the method of training a system model according to the invention or one of its preferred embodiments as defined above, wherein said system model comprises as a subunit of said system said controller model,
- performing a simulation of said system by said model for each of the different controllers
- selecting the controller with the best system performance indicator results,
- installing the selected controller into the system - in particular installing an ADAS/AV controller into a vehicle.

The object of the invention is achieved by the independent claims. The dependent claims describe advantageous developments and modifications of the invention.

According to the invention the modeling error of the system model is determined by comparing the test data with the system model data. The system test data are acquired by real system testing on the basis of the sub-set of scenarios respectively their boundary conditions. The system model data are generated by the system model data for the sub-set of scenarios by applying the system model to said scenarios.

The resulting modeling error of the system model is used for generating and training an error prediction model on basis of the modeling errors determined.

Choosing the training data according to the invention as the top error data is in particular effective to improve the model accuracy since it is most relevant for eliminating the errors detected. This method identifies uncertain scenarios that have a so called high sim2real gap. At these scenarios the simulation result is reasonably assumed to be not trustworthy and corrected by real test data from e.g., Hil, Mil, or Vil.

As a further preferred embodiment, the method may provide repeating the steps (c) - (k) until a criterion based on the determined modeling error of the trained system model is below a certain threshold. This threshold may be specified according to the practical requirements of the system to be tested and is usually determined by the requesting entity. This iterative process minimizes the modelling error by selecting the training scenarios based on the predicted error which leads to the most efficient model correction. The iteration further provides a periodic error prediction model update.

To eliminate artefacts leading to seeming modeling errors resulting from possible experimental conditions of the real testing a preferred embodiment provides that generating system model data for the sub-set of scenarios includes the additional steps of:
- randomizing each scenario of said sub-set to obtain several scenarios from one,
- generating said system model data using the randomized data as input,
- averaging said system model data obtained from the previous step for each scenario.
This enhancement will create a variety of simulations with randomized properties and train a model that works across all of them. The modelling cannot reflect varying experimental boundary conditions like changing asphalt roughness or simply sensor noise, weather, changing tire road friction during test drives but averages out these influences by the randomizing and averaging steps. The approach may be understood as teaching the error prediction model from the previous experiments of selected scenarios, randomize the simulation models to improve robustness of the simulation scenarios and reduce the gap between simulation and physical testing. Each selected scenario may be randomized with realistic parameters trying to capture the real-life environment and then averaged.

Another preferred embodiment provides the step of generating and/or training said error prediction model comprising an AI-based regression. An AI-based regression or AI Linear Regression belongs to the class of supervised machine learning algorithms. The AI-based regression is used to estimate values within a continuous range which is suitable to estimate the error of the modelling.

On the basis of the method disclosed so far, a preferred application of the invention provides a method of selecting a controller of a system from a set of different controllers. Most preferred is the selection of an ADAS/AV controller to be installed into a vehicle. The method may comprise the steps:
- defining system performance indicators,
- providing for each of the controllers of said set of different controllers a controller model,
- Performing the method of training a system model according to the method or one of its preferred embodiments as defined above, wherein said system model comprises as a subunit of said system said controller model,
- performing a simulation of said system by said model for each of the different controllers
- selecting the controller with the best system performance indicator results,
- installing the selected controller into the system.

The invention also refers to the system comprising the controller selected according to the method as defined above. This system may in particular be a vehicle comprising said controller.

Most preferred the method as defined herein is performed by a computer-system.

The scenario generation, the scenario selection, the AI-based regression preferably comprising a neural network device. The data acquisition, the training and/or the error prediction may be implemented in hardware and/or in software. If said entity is implemented in hardware, it may be embodied as a device, e.g. as a computer or as a processor or as a part of a system, e.g. a computer system. If said entity is implemented in software, it may be embodied as a computer program product, as a function, as a routine, as a program code or as an executable object.

Further possible implementations or alternative solutions of the invention also encompass combinations - that are not explicitly mentioned herein - of features described above or below with regard to the embodiments. The person skilled in the art may also add individual or isolated aspects and features to the most basic form of the invention.

Up to now, the invention has been described with respect to the claimed method. Features, advantages or alternative embodiments herein can be assigned to the other claimed objects (e.g. the computer program or a device, i.e. the apparatus or a computer program product) and vice versa. In other words, the subject matter which is claimed or de-scribed with respect to the device can be improved with features described or claimed in the context of the method and vice versa. In this case, the functional features of the method are embodied by structural units of the system and vice versa, respectively. Generally, in computer science a software implementation and a corresponding hard-ware implementation are equivalent. Thus, for example, a method step for "storing" data may be performed with a storage unit and respective instructions to write data in-to the storage. For the sake of avoiding redundancy, although the apparatus may also be used in the alternative embodiments described with reference to the method, these embodiments are not explicitly described again for the apparatus.

It is part of the invention that not all steps of the method necessarily have to be performed on the same component or computer instance but can also be performed on different computer instances.

In addition, it is possible that individual steps of the method described above can be carried out in one unit and the remaining components in another unit, as a distributed system.

The properties, features and advantages of this invention described above, as well as the manner they are achieved, become clearer and more understandable in the light of the following description and embodiments, which will be described in more detail in the context of the drawings. This following description does not limit the invention on the contained embodiments.

### BRIEF DESCRIPTION OF THE DRAWINGS

Embodiments of the invention are now described, by way of example only, with reference to the accompanying drawings, of which:
- Figure 1: shows a simplified flow diagram of a method according to the invention;
- Figure 2: shows a flow diagram of a method according to a preferred embodiment of the invention;
- Figure 4: shows a simplified schematic illustration of another preferred embodiment of the invention.

The illustration in the drawings is in schematic form. In the Figures, like reference numerals designate like or functionally equivalent elements, unless otherwise indicated.

### DESCRIPTION OF THE DRAWINGS

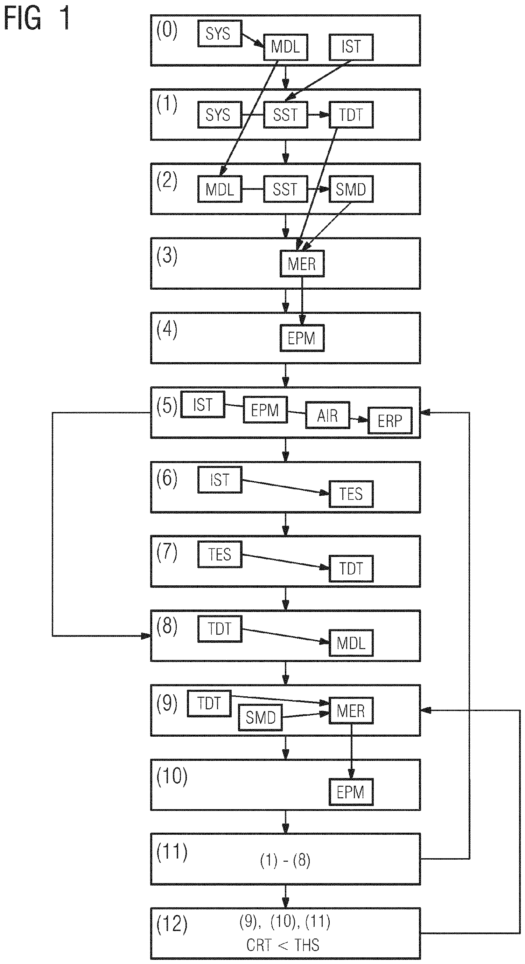

Figure 1, 2 and 3 respectively show a simplified flow diagram illustrating an example of the computer-implemented method according to the invention.

The process shown in Figure 1 comprises:
(0) providing a system model MDL of a parametrized system SYS, providing a first set IST of scenarios SCN of said system SYS,
(1) selecting a sub-set SST of scenarios SCN and acquiring system SYS test data TDT for the sub-set SST of scenarios SCN;
(2) generating system model MDL data SMD for the sub-set SST of scenarios SCN by applying the system model MDL to said scenarios SCN. The system model MDL data SMD may be generated using randomized scenarios SCN of said sub-set SST to obtain several scenarios SCN from one. Afterwards the randomized system model MDL data SMD may be averaged to obtain one system model data SMD set for each scenario SCN;
(3) determining the modeling error MER of the system model MDL by comparing the test data TDT with the system model MDL data;
(4) generating and/or training an error prediction model EPM on basis of the modeling errors determined. Training said error prediction model EPM may be done using an AI-based regression AIR;
(5) determining an error prediction ERP by the error prediction model EPM for the first set IST of scenarios SCN;
(6) selecting a certain portion of the first set IST of scenarios SCN with the highest error prediction ERP determined by the error prediction model EPM as top error scenarios TES;
(7) acquiring system SYS test data TDT for the selected top error scenarios TES;
(8) training said system model MDL with the acquired system SYS test data TDT for the selected top error scenarios TES;
(9) determining a modeling error MER of the system model MDL by comparing the test data TDT with the system model MDL data for the selected top error scenarios TES;
(10) generating and/or training an error prediction model EPM on basis of the modeling errors determined in the previous step;
(11) repeating the steps (1) - (8);
(12) repeating steps (9), (10), (11) until a criterion CRT based on the determined modeling error of the trained system model MDL is below a certain threshold THS.

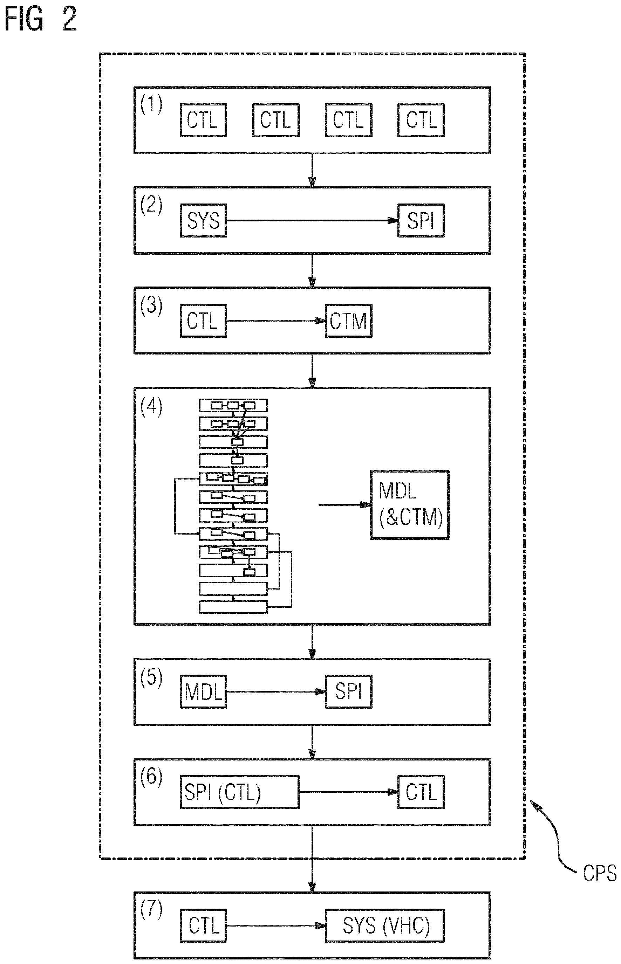

Figure 2 shows a method of selecting a controller of a system SYS, from a set of at least two different controllers CTL. These controllers CTL may preferably be ADAS/AV controller CTL to be installed into a vehicle.
As illustrated the method comprises the following steps:
(1) providing said set of controllers CTL;
(2) defining system performance indicators SPI;
(3) providing for each of the controllers CTL of said set of different controllers CTL a controller model CTM;
(4) Performing the method of training a system model MDL according to the method as described above, wherein said system model MDL comprises as a subunit of said system SYS said controller model CTM; The controller model CTM may not be part of the system model MDL training but preferably remains unchanged;
(5) performing a simulation of said system SYS by said system model MDL for each of the different controllers CTL. The simulation results are evaluated with regard to the system performance indicators SPI;
(6) selecting the controller CTL with the best system SYS performance indicator SPI results according to the simulation of the respective system SYS via the system model MDL.

The controller CTL selection strategy may choose from the simulation results several top candidates of controllers CTL with similar good results for further optimization loops following a more complex iterative optimizing selection strategy with specific amendment approaches of the selected controllers CTL of maybe exchanging controller aspects between the top controller candidates.

Finally, the result may be implemented by:
(7) installing the selected controller into the system SYS.

The system SYS may be a vehicle VHC and the controller CTL may be an ADAS and/or AV controller CTL.

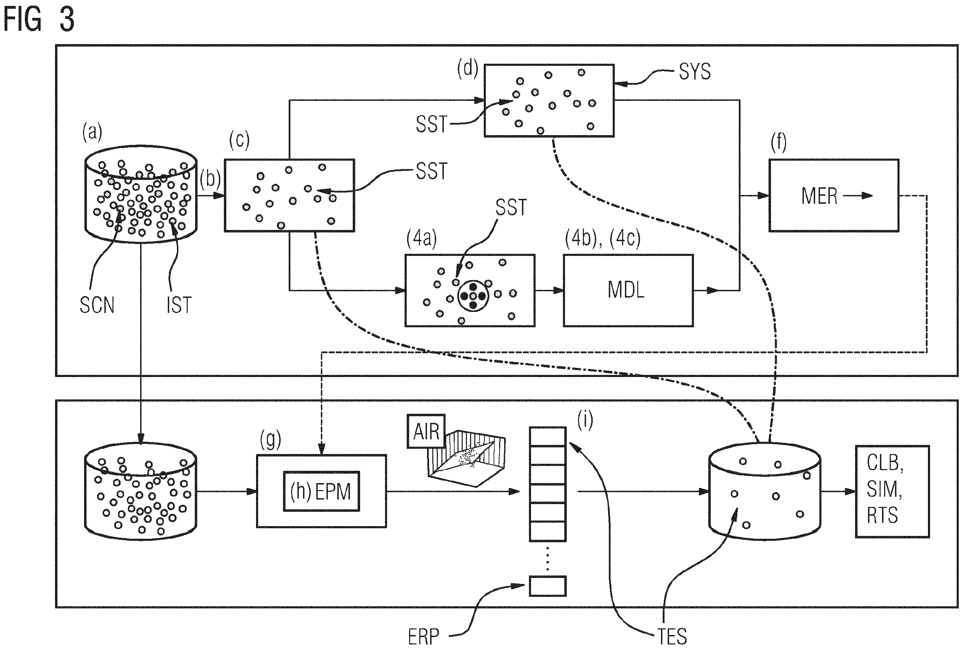

Figure 3 illustrates the method according to a preferred embodiment of the invention.

The method begins with providing a first set IST of scenarios SCN of said system SYS in step (b). As explained before a sub-set SST of scenarios SCN is selected (step (c)). The sub-set SST subsequently is used for two processes in parallel. In a step (d) system test data TDT for the sub-set SST of scenarios SCN are acquired. In a step (4a) the sub-set SST is randomized and in step (4b) system model MDL data for the sub-set SST of scenarios SCN by applying the system model MDL are generated. The resulting system model MDL data is averaged (step (4c)) for each scenario SCN to compensate the increase of scenario numbers from the randomization. Subsequently - in step (f) the test data TDT is compared with the system model MDL data to determine the modeling error MER.

The modeling error MER is used in step (g) for generating and/or training an error prediction model EPM. This is done by AI-based regression AIR.

For the full first set IST of scenarios SCN an error prediction ERP is determined by the error prediction model EPM in step (h).

In step (i) the error prediction ERP is ranked and a certain portion of the first set IST of scenarios SCN with the highest error prediction determined by the error prediction model EPM is selected as top error scenarios TES. Subsequently - as described above - the system model MDL is calibrated CLB and the selected as top error scenarios TES are added to a new data set for simulation SIM and real testing RTS.

The complete method or part of the method may be performed by a computer-system CPS. The computer system may be fully or partly part of a cloud computing system.

Although the present invention has been described in detail with reference to the preferred embodiment, it is to be understood that the present invention is not limited by the disclosed examples, and that numerous additional modifications and variations could be made thereto by a person skilled in the art without departing from the scope of the invention.

It should be noted that the use of "a" or "an" throughout this application does not exclude a plurality, and "comprising" does not exclude other steps or elements. Also, elements described in association with different embodiments may be combined. It should also be noted that reference signs in the claims should not be construed as limiting the scope of the claims.

Independent of the grammatical term usage, individuals with male, female or other gender identities are included within the term.

## Claims

1. A computer-implemented method for training a predefined system model (MDL) of a parametrized system (SYS), wherein scenarios (SCN) are a parameter set defining a system (SYS) state and/or system (SYS) operation, the method comprising:
(a) providing said system model (MDL) of a parametrized system (SYS),
(b) providing a first set (IST) of scenarios (SCN) of said system (SYS),
(c) selecting a sub-set (SST) of scenarios (SCN),
(d) acquiring system (SYS) test data (TDT) for the sub-set (SST) of scenarios (SCN),
(e) generating system model (MDL) data for the sub-set (SST) of scenarios (SCN) by applying the system model (MDL) to said scenarios (SCN),
(f) determining a modeling error (MER) of the system model (MDL) by comparing the test data (TDT) with the system model (MDL) data,
**characterized by** the additional steps:
(g) generating and/or training an error prediction model (EPM) on basis of the modeling errors (MER) determined,
(h) determining an error prediction (ERP) by the error prediction model (EPM) for the first set (IST) of scenarios (SCN),
(i) selecting a certain portion of the first set (IST) of scenarios (SCN) with the highest error prediction (ERP) determined by the error prediction model (EPM) as top error scenarios (TES),
(j) acquiring system (SYS) test data (TDT) for the selected top error scenarios (TES),
(k) training said system model (MDL) with the acquired system (SYS) test data (TDT) for the selected top error scenarios (TES).

2. Method according to claim 1, wherein the method comprises:
repeating steps (c) - (k) until a criterion based on the determined modeling error of the trained system model (MDL) is below a certain threshold (THS).

3. Method according to claim 1 and/or 2, wherein the step (g) of generating and/or training said error prediction model (EPM) comprises an AI-based regression (AIR).

4. Method according to at least one of the previous claims, wherein generating system model (MDL) data for the sub-set (SST) of scenarios (SCN) includes:
- randomizing each scenario (SCN) of said core-set (SST) to obtain several scenarios (SCN) from one,
- generating said system model (MDL) data using the randomized data as input,
- averaging said system model (MDL) data obtained from the previous step for each scenario (SCN).

5. Method of selecting a controller (CTL) of a system (SYS), from a set of different controllers (CTL), in particular of selecting an ADAS/AV controller (CTL) to be installed into a vehicle comprising:
- defining system (SYS) performance indicators,
- providing for each of the controllers (CTL) of said set of different controllers (CTL) a controller model (CTM),
- Performing the method of training a system model (MDL) according to at least one of the previous claims 1 - 4, wherein said system model comprises as a subunit of said system (SYS) said controller model (CTM),
- performing a simulation of said system (SYS) by said model for each of the different controllers (CTL),
- selecting the controller (CTL) with the best system (SYS) performance indicator results.

6. Computer-system (CPS) for performing the method according to at least one of the claims 1-5.

7. System (SYS) in particular vehicle comprising a controller selected by a method according to at least one of the claims 1-5.
